(19) Europäisches Patentamt

European Patent Office

Office européen des brevets

(11) **EP 1 020 996 A1**

(12) **EUROPEAN PATENT APPLICATION**

(43) Date of publication:
**19.07.2000 Bulletin 2000/29**

(51) Int. Cl.$^7$: **H03M 13/27**

(21) Application number: **00100155.1**

(22) Date of filing: **11.01.2000**

| | |
|---|---|
| (84) Designated Contracting States:<br>**DE GB**<br>Designated Extension States:<br>**AL LT LV MK RO SI**<br><br>(30) Priority: **14.01.1999 JP 754099**<br><br>(71) Applicant: **NEC CORPORATION**<br>**Tokyo (JP)** | (72) Inventor: **Tsuneki, Kiyoshi**<br>**Minato-ku, Tokyo (JP)**<br><br>(74) Representative:<br>**VOSSIUS & PARTNER**<br>**Siebertstrasse 4**<br>**81675 München (DE)** |

(54) **Interleaver/de-interleaver, method of interleaving/de-interleaving, and transmitter/receiver using the same**

(57)    An interleaver, according to the present invention, is comprised of an address table generation unit 1, made up of an address pattern memory unit 14, two counters 11-1 and 11-2, a multiplexer 12, a memory controller 13, an initializing unit 800, and an adder 15. On reception of an operation start signal from the frame controller 3, the initializing unit 800 initializes the two counters 11-2 and 11-1 and they then start their respective operations in sync with a clock signal. The address pattern memory unit 14 is stored with a set of row data bits A (i) and a set of column data bits B (j); where the integer i is equal to the quotient resulting from dividing a bits-address k by N, and the integer j is equal to the remainder resulting from the above calculation. The integers i and j or the quotient and remainder are given by a multiplexer 12. On reception of the integers i and j, the memory controller 13 gives the address pattern memory unit 14 an address corresponding to the integers i and j. An address data A(i) and [B(j) x M] are then read out from the given address of the address pattern memory unit 14. Then they are summed into an address data R(k) by the adder 15. The resultant address data R(k) is then output to the reading address controller 6.

Fig.3

**Description**

The present invention relates to an interleaver/de-interleaver, a method of interleaving/de-interleaving, and a transmitter/receiver used in mobile communication devices such as cellular telephones.

For mobile communication with cellular telephones, input data bits need to be subjected to an interleaving process so that possible burst errors can be decentralized. Interleaving methods that effectively decentralize the data bits have also been proposed. (See "Multi-level Interleaving Methods for W-CDMA and Their Applicable Results" IEICE Technical Report, The Institute of Electronics, Information, and Communication Engineers, Feb. 1998.)

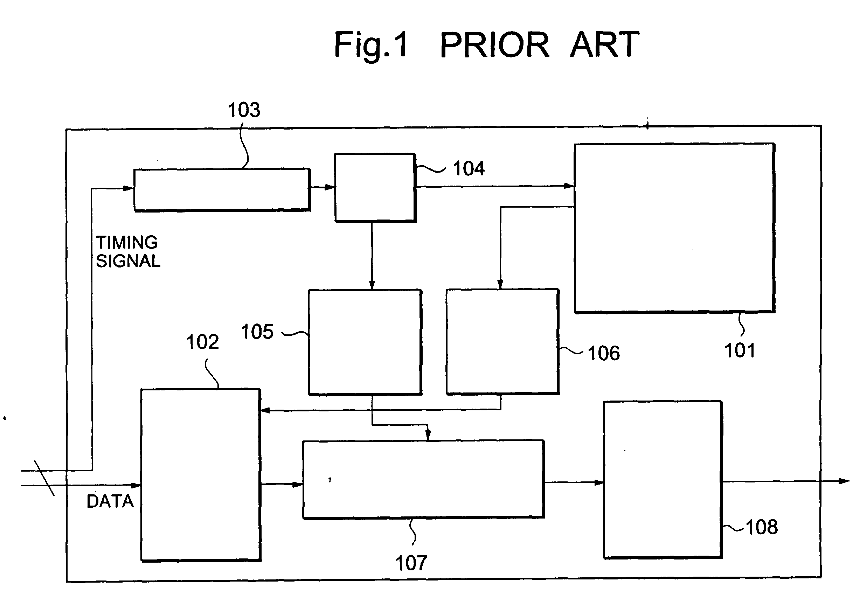

Fig. 1 is a block diagram showing the conventional multi-interleaver. The conventional multi-interleaver is comprised of the following components:

- An input buffer 102, which stores a series of input data bits into chronologically ascending addresses,
- A frame controller 103, which detects the input of the first frame of the series of data bits and indicates the start of interleaving,
- A counter 104, which counts once the interleaving begins,
- A writing address controller 105, which outputs an address dependent upon the output from counter 104, to the interleave 107.
- An address table memory unit 101, which stores the order of the data bits after array substitution in a table,
- A reading address controller 106, which outputs the physical address of a data bit stored in the input buffer 102 to it in conformity with the address output from this address table memory unit 101.
- An interleave controller 107, which performs the substitution of the data bits, and
- An output buffer 108, which temporarily stores the signal output from the interleave controller 107.

Moreover, the address table memory is stored with the addresses for, for example, 24 bits of data, with the addresses being arranged in the order of 0, 12, 6, 18, 2, 14, 8, 20, 4, 16, 10, 22, 1, 13, 7, 19, 3, 15, 9, 21, 5, 17, 11, 23.

Here, the interleaving process for 24 (4 [2 x 2] x 6 [3 x 2]) bits of data will be described. First, the input bits of data are horizontally stored in a (4 x 6) imaginary matrix, as shown in table 1 below. The values in table 1 denote the input order of the data bits, and also indicate the respective addresses of the input bits of data stored in the input buffer 102.

[Table 1]

| 0 | 1 | 2 | 3 | 4 | 5 |
|---|---|---|---|---|---|

[Table 1] (continued)

| 6 | 7 | 8 | 9 | 10 | 11 |
|---|---|---|---|---|---|
| 12 | 13 | 14 | 15 | 16 | 17 |
| 18 | 19 | 20 | 21 | 22 | 23 |

Next, the first row of the above address table 1 is written horizontally in a (3 x 2) imaginary matrix, as shown below in table 2.

[Table 2]

| 0 | 1 |
|---|---|
| 2 | 3 |
| 4 | 5 |

Once this has been completed, the address data of the address table 1 is redistributed based on table 2, as shown in table 3.

[Table 3]

| 0 | 2 | 4 | 1 | 3 | 5 |
|---|---|---|---|---|---|
| 6 | 8 | 10 | 7 | 9 | 11 |
| 12 | 14 | 16 | 13 | 15 | 17 |
| 18 | 20 | 22 | 19 | 21 | 23 |

Once again, the first column of address table 3 is written horizontally in a (2 x 2) imaginary matrix as shown in table 4 below.

[Table 4]

| 0 | 6 |
|---|---|
| 12 | 18 |

After this has been completed, the address data of the address table 3 is redistributed based on table 4, as shown in table 5.

[Table 5]

| 0 | 2 | 4 | 1 | 3 | 5 |
|---|---|---|---|---|---|
| 12 | 14 | 16 | 13 | 15 | 17 |
| 6 | 8 | 10 | 7 | 9 | 11 |
| 18 | 20 | 22 | 19 | 21 | 23 |

Since vertically reading out the address data in table 5 can assist to arrange the input bits of data, the address data in table 5 is stored in the address table memory unit 101.

According to the conventional multi-level interleaver in Fig 1, when the interleaving begins, the counting of the number of input bits is started.

At each time of the counting, a piece of address data in table 5 is read out from the address table memory unit 101, in the columnar order of table 5, and then output. As a result, the pieces of address data are output in the order of 0, 12, 6, 18, 2, 14, 8, 20, 4, 16, 10, 22, 1, 13, 7, 19, 3, 15, 9, 21, 5, 17, 11, 23.

The interleave controller 107 reorders the bits of data stored in the input buffer 102 in the order as described above, thus outputting and storing them in the output buffer 108. The output buffer 108 then outputs each of the stored bits one after another.

As a result, a possible burst error can be effectively dispersed so that error corrections can be performed without difficulty.

The above multi-level interleaver in Fig. 1 is used for a transmitter, whereas its corresponding multi-level de-interleaver is used for a receiver.

Next, the operation of the multi-level de-interleaver in the case where the address table memory unit 101 is stored with the pieces of address data as shown in table 6, will be described.

[Table 6]

| 0 | 1 | 2 | 3 | 4 | 5 |
|----|----|----|----|----|----|
| 6 | 7 | 8 | 9 | 10 | 11 |
| 12 | 13 | 14 | 15 | 16 | 17 |
| 18 | 19 | 20 | 21 | 22 | 23 |

When the address table used is as shown in table 6, data bits are transmitted from the transmitter with the order of the addresses being 0, 6, 12, 18, 1, 7, 13, 19, 2, 8, 14, 20, 3, 9, 15, 21, 4, 10, 16, 22, 5, 11, 17, 23. Accordingly, the de-interleaver performs an interleave of the (6 x 4) imaginary matrix. Namely, received data bits are horizontally stored in the (6 x 4) imaginary matrix, as shown in table 7 below.

[Table 7]

| 0 | 6 | 12 | 18 |
|----|----|----|----|
| 1 | 7 | 13 | 19 |
| 2 | 8 | 14 | 20 |
| 3 | 9 | 15 | 21 |
| 4 | 10 | 16 | 22 |
| 5 | 11 | 17 | 23 |

The stored data bits are then read out vertically beginning at the first column one after another. As a result, the data bits are rearranged and restored to their original address order of 0, 1, 2, ... , 23.

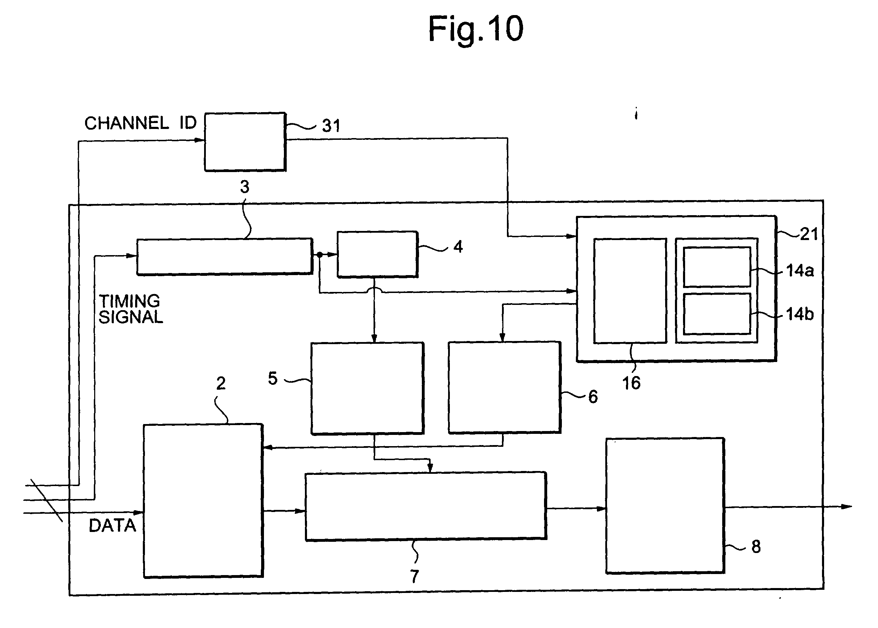

There are also multi-channel adjustable interleavers. Fig. 10 is a block diagram showing the conventional multi-channel adjustable multi-level interleaver.

Address table memory 101a is stored with several tables for various communication channels. Furthermore, a microprocessor 111 selects one of the said several tables in accordance with the kind of one of the communication channels.

However, there is a problem with the conventional interleaver in that, regardless of the multi-channel adjustor, an address table memory unit with a large capacity is necessary in order to store the same number of addresses as the input data bits.

The present invention has been made by taking the above problems into account. An objective of the present invention is to provide an interleaver and interleaving method, and a de-interleaver and de-interleaving method, which are able to reduce the necessary capacity of a memory unit. Another objective of the present invention is to provide a transmitter and receiver comprised of the said interleaver and de-interleaver.

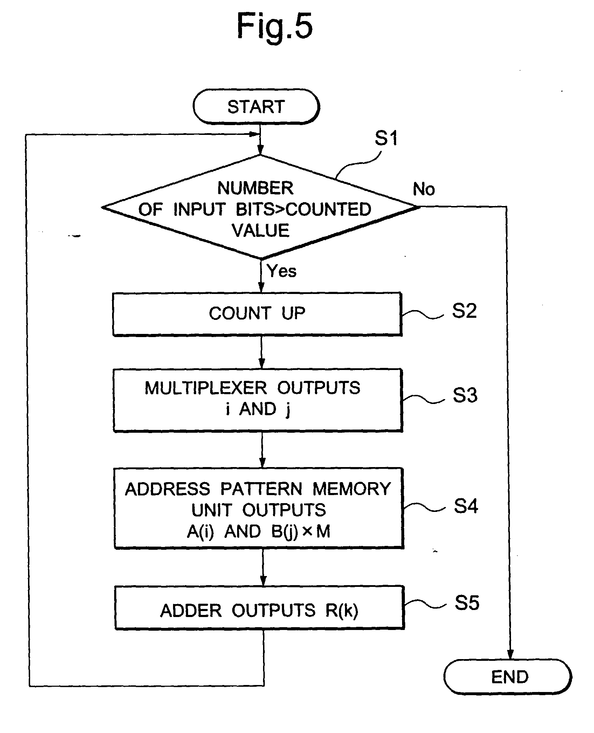

According to an aspect of the present invention, a method of interleaving pieces of data is provided, and is comprised of the following steps: a relocation-address calculation step of calculating a relocation address (R(k)) on the first row (A(i)) and the first column (B(j)) of address elements in a matrix, which has a desired relocation-address arrangement, and an address (k) of a piece of data; and a relocation step of relocating the said piece of data into the said relocation address (R(k)). An example of the method of interleaving is illustrated in Fig. 5.

According to an aspect of the present invention, a method of de-interleaving pieces of data is provided, and is comprised of the following steps: a relocation-address calculation step of calculating a relocation address (R(k)) on the first row (A'(i)) and the first column (B'(j)) of address elements in a matrix, which has a desired relocation-address arrangement, and an address (k) of a piece of data; and a relocation step of relocating the said piece of data into the said relocation address (R(k)); wherein the address elements in the said first row (A'(i)) are equal to the address elements in the first column (B(j)) in a matrix, which has a desired relocation-address arrangement that is used for an interleaving method; the address elements in the said first column (B'(j)) are equal to the address elements in the first row (A(i)) in the said matrix. An example of the method of interleaving is illustrated in Fig. 5.

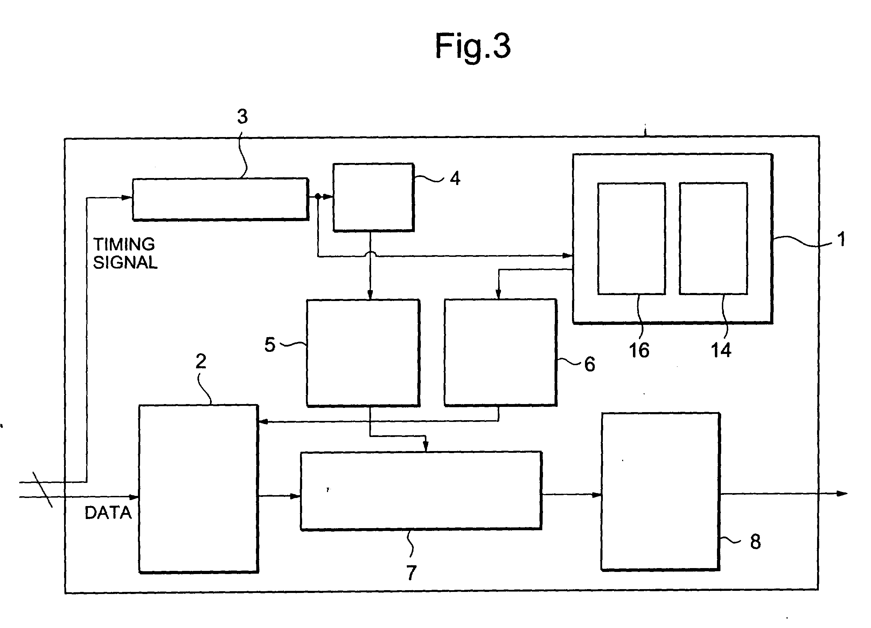

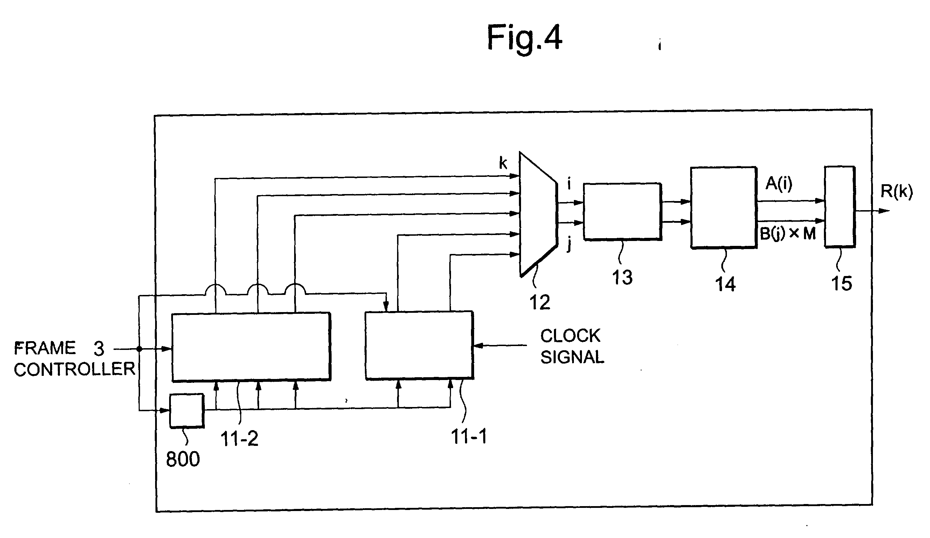

According to an aspect of the present invention, an interleaver is provided, and is comprised of the following components: a relocation-address calculator (1, 3), which calculates a relocation address (R(k)) on the first row (A(i)) and the first column (B(j)) of address elements in a matrix with a desired relocation-address arrangement, and an address (k) of a piece of data; and a relocation unit (6, 7, 5, 4), which relocates the said piece of data into the said relocation address (R(k)). An example of the interleaver is illustrated in Figs. 3 and 4.

According to an aspect of the present invention, a de-interleaver is provided, and is comprised of the following components: a relocation-address calculator (3, 1), which calculates a relocation address (R(k)) on the first row (A'(i)) and the first column (B'(j)) of address elements in a matrix with a desired relocation-address arrangement, and an address (k) of a piece of data; and a relocation unit (6, 7, 5, 4), which relocates the said piece of data into the said relocation address (R(k)); wherein the address elements in the said first row (A'(i)) are equal to the address elements in the first column (B(j)) in a matrix, which has a desired relocation-address arrangement that is used for an interleaving method; the address elements in the said first column (B'(j)) are equal to the address elements in the first row (A(i)) in the said matrix.

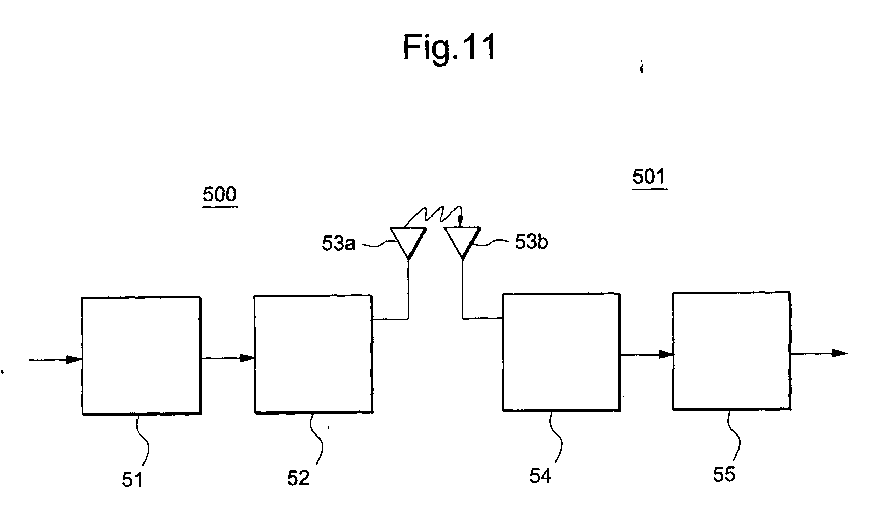

According to an aspect of the present invention, a transmitter is provided, and is comprised of the following components: an encoder, which encodes transmission data; and an interleaver, comprised of the following units: a relocation-address calculator (1, 3), which calculates a relocation address (R(k)) on the first row (A(i)) and the first column (B(j)) of address elements in a matrix with a desired relocation-address arrangement, and an address (k) of a piece of the encoded transmission data; and a relocation unit (6, 7, 5, 4), which relocates the said piece of the encoded transmission data into the said relocation address (R(k)). An example of the transmitter is illustrated in Fig. 11.

According to an aspect of the present invention, a receiver is provided, and is comprised of the following components: a de-interleaver, comprised of the following units: a relocation-address calculator (3, 1), which calculates a relocation address (R(k)) on the first row (A'(i)) and the first column (B'(j)) of address elements in a matrix with a desired relocation-address arrangement, and an address (k) of a piece of encoded data: and a relocation unit (6, 7, 5, 4), which relocates the said piece of encoded data into the said relocation address (R(k)); wherein the address elements in the said first row (A'(i)) are equal to the address elements in the first column (B(j)) in a matrix, which has a desired relocation-address arrangement that is used by a transmitter; the address elements in the said first column (B'(j)) are equal to the address elements in the first row (A(i)) in the said matrix; and a decoder, which decodes each pieces of the relocated, encoded data. An example of the transmitter is illustrated in Fig. 11.

The above and other objects, features and advantages of the present invention will become more apparent from the following detailed description, when taken in conjunction with the accompanying drawings, wherein:

Fig. 1 illustrates the conventional multi-level interleaver;

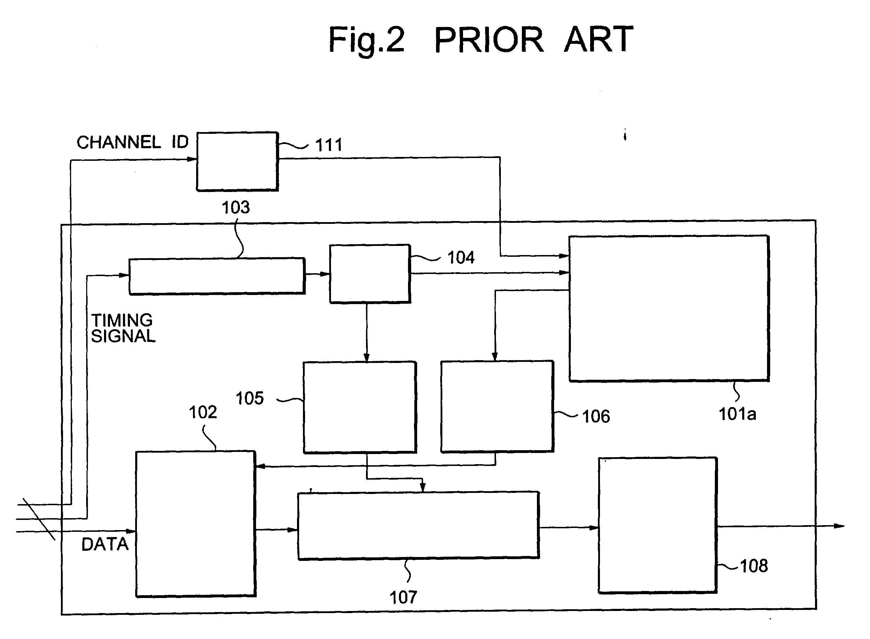

Fig. 2 illustrates the conventional multi-level interleaver that can support multiple channels;

Fig. 3 illustrates an interleaver, according to the first embodiment of the present invention;

Fig. 4 illustrates an address table generation unit 1 in the interleaver of the first embodiment;

Fig. 5 is a flowchart illustrating the operation of the address table generation unit 1;

Fig. 6 illustrates an interleaver, according to the second embodiment of the present invention;

Fig. 7 illustrates an address table generation unit 21 in the interleaver of the second embodiment;

Fig. 8 illustrates an interleaver, according to the third embodiment of the present invention;

Fig. 9 illustrates an address table generation unit in the interleaver of the third embodiment;

Fig. 10 illustrates an interleaver, according to the forth embodiment of the present invention;

Fig. 11 illustrates a transmission and reception apparatus, according to the fifth embodiment of the present invention, and

Fig. 12 illustrates a microprocessor system, according to the sixth embodiment of the present invention, which interleaves and de-interleaves input data bits.

Several embodiments of the present invention will be described while referencing the figures.

First embodiment

An interleaver, according to the first embodiment of the present invention, will be described with reference to Figs. 3 and 4.

The interleaver of the first embodiment executes a (4 [2 x 2] x 6 [3 x 2] (N=4, M=6))-type interleaving process dealing with, for example, 24 bits of data. In Fig. 3, the interleaver is comprised of an input buffer 2, which temporarily accumulates input data bits. It is also comprised of a frame controller 3, which detects when the first frame of data bits is input and then sends an operation start signal to a counter 4 and an address table generation unit 1 (more specifically, to the two counters 11-2 and 11-1, as well as the initializing unit 800 in Fig. 4, which are later described). Accordingly, the counter 4 counts up in the increasing order of 0, 1, 2, ... 23, and outputs each counted value to a writing address controller 5. The writing address controller 5 generates a physical memory address corresponding to the each of the said counted values, which is used to designate the memory location in an output buffer 8 where a data bit read out from the input buffer 2 should be stored via the interleave controller 7.

Upon reception of the operation start signal from the frame controller 3, the address table generation unit 1 starts calculating the pattern of address data used to change the order of the input data bits. As shown in Fig. 3, the address table generation unit 1 is comprised of a logic circuit 16 and an address pattern memory unit 14. Fig. 4 illustrates the detailed configuration of the address table generation unit 1.

In Fig. 4, the address table generation unit 1 is made up of the address pattern memory unit 14 and the other part or the logic circuit 16 as described above. The logic circuit 16 is made up of the two counters 11-1 and 11-2, a multiplexer 12, a memory controller 13, a initializing unit 800, and an adder 15. On reception of the operation start signal from the frame controller 3, the initializing unit 800 initializes the two counters 11-2 and 11-1 and they start their respective operations in sync with the clock signal. The address pattern memory unit 14 is stored with a set of row data bits $A(i)$ and a set of column data bits $B(j)$:

$$A(i) = 0, 2, 4, 1, 3, 5$$
$$B(j) = 0, 2, 1, 3$$

where the integer variable $i$ is a suffix of the array $A(i)$, and the integer variable $j$ is a suffix of the array $B(j)$. Accordingly, $A(0)$ denotes the first array element of 0; $A(1)$, the second array element of 2; ... ; $A(5)$, the sixth array element of 5. On the other hand. $B(0)$ denotes the first array element of 0; $B(1)$, the second array element of 2; ... ; $B(3)$, the fourth array element of 3. Naturally, designating a certain value to the suffix $i$ allows the array $A(i)$ to provide its corresponding array element. In the same manner, designating a certain value to the suffix $j$ allows the array $B(j)$ to provide its corresponding array element. The quotient resulting from dividing a bits-address $k$ (shown in table 5) by N (i.e., 4, in the case of the first embodiment) is given to the suffix $i$, whereas the remainder resulting from the above division is given to the suffix $j$.

The numeral elements of $A(i)$ are equal to those in the first row of table 5, whereas the numeral elements of $B(j)$ are equal to those in the first column of the same table. It is noted that a set of column data (hereafter, called $[B(j) \times M]$ or $[B(j) \times 6]$) resulting from multiplying $B(j)$ by M (i.e., 6 in the case of this embodiment) can be used in place of the above a set of $B(j)$. The above integers $i$ and $j$ or the quotient and remainder are given by a multiplexer 12.

The multiplexer 12, connected to the two counters (the 3-bit counter 11-2 and the 2-bit counter 11-1), multiplexes the input address data $k$ transmitted from the two counters and outputs the integers $i$ and $j$ to the memory controller 13. The 2-bit counter 11-1 outputs the two lower significant bits of the address data, whereas the 3-bit counter 11-2 outputs the three upper significant bits. As described above, upon reception of the operation start signal from the frame controller 3 in Fig. 3, the two counters start cooperating to count up in the increasing order of 0, 1, 2, ... , 23, thus outputting each of the counted values to the multiplexer 12. This operation by the two is executed in sync with the counter 4 in Fig. 3. The 2-bit counter 11-1 operates in sync with a clock signal, which is also timed to be in sync with the counting by the counter 4. The 2-bit counter 11-1 also outputs a rippled carry signal to the 3-bit counter 11-2 when the counting value becomes 3 or the binary values "11". On reception of the rippled carry signal, the 3-bit counter 11-2 counts up by one. In other words, the 3-bit counter 11-1 counts up at every four clock signals. These operations by the two counters allow the counting to occur in the increasing order of 0, 1, 2, ..., 23.

Upon reception of the integers $i$ and $j$, the memory controller 13 gives the address pattern memory unit 14 an address corresponding to the integers $i$ and $j$. The address data $A(i)$ and $[B(j) \times M]$ are then read out from the given address of the address pattern memory unit 14. The read out address data $A(i)$ and $[B(j) \times M]$ are then summed into an address data $R(k)$ by the adder 15. The resultant address data $R(k)$ is then output to the reading address controller 6.

In Fig. 3, on reception of the address data $R(k)$, the reading address controller 6 gives the input buffer 2 a physical address corresponding to the address data $R(k)$. A data bit stored in the address of the input buffer 2 directed by the address data $R(k)$ is then read out and output to the interleave controller 7. Upon reception of the data bit from the input buffer, the interleave controller 7 gives an output buffer 8 a physical address, which is received from the writing address controller 5, and the received data bit. The output buffer accordingly stores the data bit in the physical address.

Next, the detailed operation of the first embodiment will be described while referencing Fig. 5. Fig. 5 is a flowchart showing the operation of the interleaver of the first embodiment. On reception of an operation start signal from the frame controller 3, the interleaver of the present invention begins the interleaving of the input data bits. At this time, a frame of data bits has been stored in the input buffer 2.

In step S1, it is determined whether the number of input data bits (stored in the input buffer 2) is larger than the counted value in the counter 4. If yes, in step S2, one is added to the address data $k$ by the two counters 11-1 and 11-2 in the address table generation unit 1. Also, the counter 4 adds one to the internal count value. In step S3, the address table generation unit 1 generates the integers $i$ and $j$, depending upon the address data $k$. In step S4, row address data $A(i)$ and column address data $[B(j) \times M]$ (i.e., 6 in the case of this embodiment) are output from the address pattern memory unit 14, in the manner described above. Afterwards, in step S5, the summed value $R(k)$ of these pieces of address data is calculated, and then output to the reading address controller 6. Thereafter, the processes beginning at step S1 is repeatedly executed in the same manner as described above until all the input data bits in the input buffer 2 are processed.

In more detail, when $k = 0$, $(i, j) = (0, 0)$. $R(0)$

= A (0) + B (0) x 6 = 0 is then obtained from the address table generation unit 1. When k = 1, (i, j) = (0, 1). Accordingly, R(1) = A(0) + [B(1) x 6] = 12 is then obtained. When k = 2, (i, j) = (0, 2). Accordingly, R(2) = A(0) + [B(2) x 6] = 6 is then obtained. When k = 3, (i, j) = (0, 3). Accordingly, R(3) = A(0) - [B(3) x 6] = 18 is then obtained. When k = 12, (i, j) = (3, 0). Accordingly, R(12) = A(3) + [B(0) x 6] = 1 is then obtained. When k = 23, (i, j) = (5, 3). Accordingly, R(23) = A(5) + [B(3) x 6] = 23 is then obtained.

In this manner, a series of address data R(k) = 0, 12, 6, 18, 2, 14, 8, 20, 4, 16, 10, 22, 1, 13, 7, 19, 3, 15, 9, 21, 5, 17, 11, 23 can be calculated.

As described above, according to this embodiment, only 10 pieces of data including A(i) = 0, 2, 4, 1, 3, 5 and B(j) = 0, 2, 1.3 are needed in the address pattern memory unit 14 so that the input data bits can be efficiently relocated.

Second embodiment

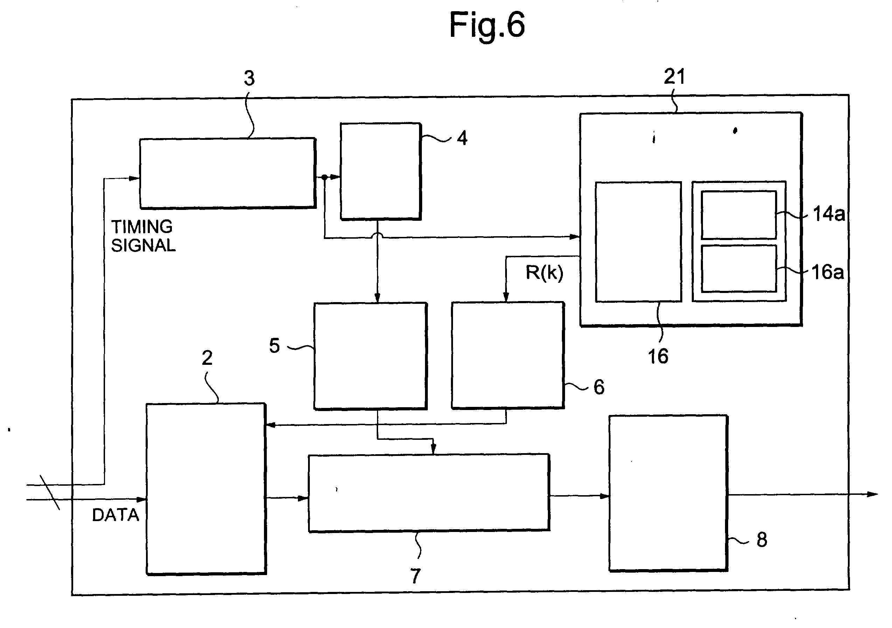

Next, an interleaver, according to the second embodiment of the present invention, will be described while referencing Fig. 6. It is noted that the same functional elements as those in Fig. 3 are assigned the same reference numerals in this figure. In the second embodiment, the series of row data A(i) as described above can be given by an operation similar to that of the address table generation unit 1 of the first embodiment. The interleaver of the second embodiment is comprised of an address table generation unit 21, which calculates a series of address data used for relocating the input data bits.

The address table generation unit 21 is comprised of an address pattern memory unit 14a and logic circuits 16 and 16a. The address pattern memory unit 14a is stored with a series of row data B(j), a series of row data C(m), and a series of column data D(n):

    B(j) = 0, 2, 1, 3
    C(m) = 0, 1, 2
    D(n) = 0, 1

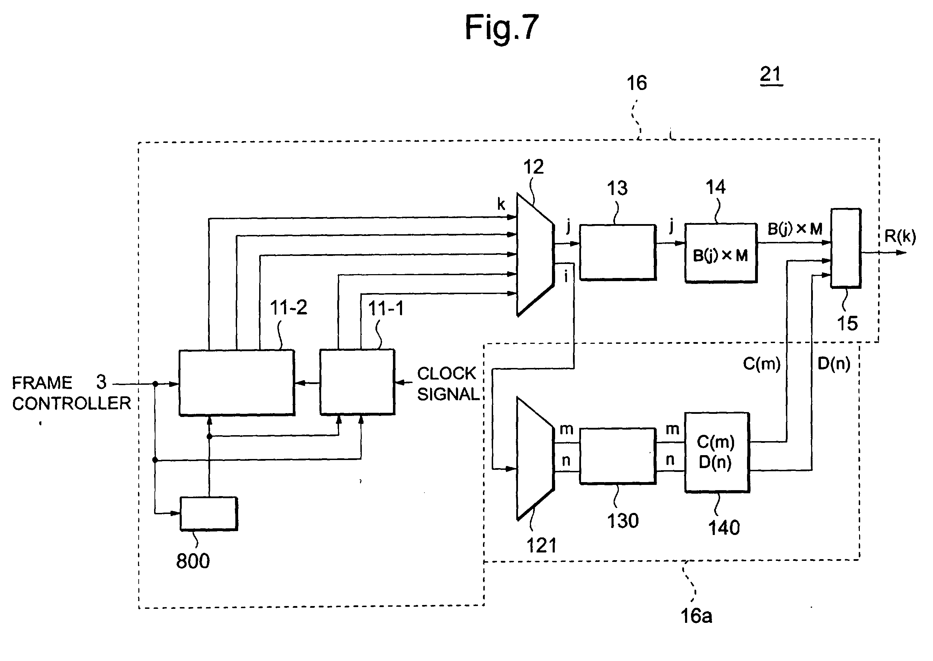

where the integer n is equal to the quotient resulting from dividing the integer i by 3, and the integer m is equal to the remainder resulting from the above calculation. An operation equivalent to this division can be executed by a multiplexer 121, which is described later while referencing Fig. 7. It is noted that a set of column data (hereafter, called [C(m) x 2]) resulting from multiplying C(m) by 2 can be used in place of the above set C(m).

Fig. 7 illustrates the detailed configuration of the address table generation unit 21. The same functional elements as those in Fig. 4 are assigned the same reference numerals in this figure. In Fig. 7, the circuit 16 is equivalent to that of Fig. 4 except for the following:

- the multiplexer 12 outputs the integer i to the multiplexer 121 (not to the memory controller 13):
- the memory controller 13 gives the address pattern memory unit 14 only a signal corresponding to the integer j accordingly;
- the address pattern memory 14, stored with only [B(j) x M], outputs a numeral element of [B(j) x M] corresponding to the integer j to the adder 15 accordingly; and
- the adder 15 adds three inputs: [B(j) x M], C(m), and D(n) together.

The circuit 16a generates the numeral elements of the respective C(m), and D(n) in such a manner as described above. These numeral elements are added together into A(i) by the adder 15. The circuit 16a is comprised of an address pattern ROM 140, a memory controller 130, and the multiplexer 121. The address pattern ROM 140 is stored with the numeral elements of the respective C(m) and D(n).

With this configuration, on reception of an operation start signal from the frame controller 3 in Fig. 6, the multiplexer 12 in the address table generation unit 21 generates the integers i and j depending on k at the time of adding one to the value of k. At the same time, the integers m and n are also generated from the integer i by the multiplexer 121. The memory controller 130 then gives the address pattern ROM 140 the integers m and n as an address. The address pattern ROM 140 then reads out a numeral element of C(m) and a numeral element of D(n) from the given address. The numeral elements are then added together into A(i), which is also added to the numeral element of [B(j) x M] read out from the address pattern memory 14 by the adder 15 outputting its resulting R(k). The following description shows the relationship between the integer i and A(i).

For example, when i = 0, (n, m) = (0, 0). Accordingly, A(0) = D(0) + C(0) x 2= 18 is then obtained. When i = 1, (n, m) = (0, 1). Accordingly, A(1) = D(0) - C(1) x 2= 2 is then obtained. When i = 2, (n, m) = (0, 2). Accordingly, A(0) = D(0) + [C(2) x 2] = 4 is then obtained. When i = 3, (n, m) = (1, 0). Accordingly, A(3) = D(1) + [C(0) x 2] = 1 is then obtained. When i = 4, (n, m) = (1, 1). Accordingly, A(4) = D(1) + [C(1) x 2] = 3 is then obtained. When i = 5, (n, m) = (1, 2). Accordingly, A(5) = D(1) + [C(2) x 2] = 5 is then obtained. As a result, the series of row data A(i) = 0, 2, 4, 1, 3, 5 are obtained.

Afterwards, the input data bits stored in the input buffer 2 are relocated using the obtained row data A(i) and column data B(j).

As described above, according to the second embodiment, only 9 pieces of data including the column data B(j), the column data C(m), and the row data D(n) are needed in the address pattern memory unit 14a in order for the input data bits stored in the input buffer 2 to be efficiently relocated.

Incidentally, the series of column data B(j) can be naturally obtained in the same manner as A(i) is obtained as described above.

In addition, the interleavers, according to the first and second embodiments of the present invention, are structured so that 24 bits of data can be subjected to the interleaving process. However, the present invention is not limited to this. The interleaver can be easily designed with a small capacity address pattern memory unit used to relocate any number of data bits, in the same manner as the first and second embodiments are designed. The more data bits there are, the more the result of decreasing the necessary capacity of the address pattern memory unit is improved. If it is necessary for 384 bits of data, for example, to be relocated, and these bits are arranged in a 24-by-16 matrix, a correspondingly designed interleaver, according to the present invention, needs a small capacity to store only 40 (24 + 16) pieces of address data. In this case, the interleaver subjects the 384 bits of data to a ( 24 [4(2 x 2) x 6(3 x 2)] x 16 [4(2 x 2)x 4(2 x 2)x 4(2 x 2)] )-type interleaving process. Furthermore, executing a thee-level interleaving process requires a smaller capacity for storing only 17 (2 + 2 - 3 + 2 + 2 + 2 + 2 + 2) pieces of address data. Furthermore, if it is necessary for 27,648 bits of data, for example, to be relocated, and these bits are arranged in an matrix of 216-by-128, a correspondingly designed interleaver, according to the present invention, needs a small capacity to store only 308 (216 + 128) pieces of address data. In this case, the interleaver subjects the 27,648 bits of data to a ( 216{12[4(2 x 2)x 3] x 18[3 x 6(2 x 3)]} x 128{16[4(2 x 2)x 4(2 x 2)] x 8[4(2 x 2) x 2]} )-type interleaving process. Furthermore, executing a four-level interleaving process requires an even smaller capacity to store only 29 (2 + 2 + 3 + 3 + 2 + 3 + 2 + 2 + 2 + 2 + 2 + 2) pieces of address data.

Third embodiment

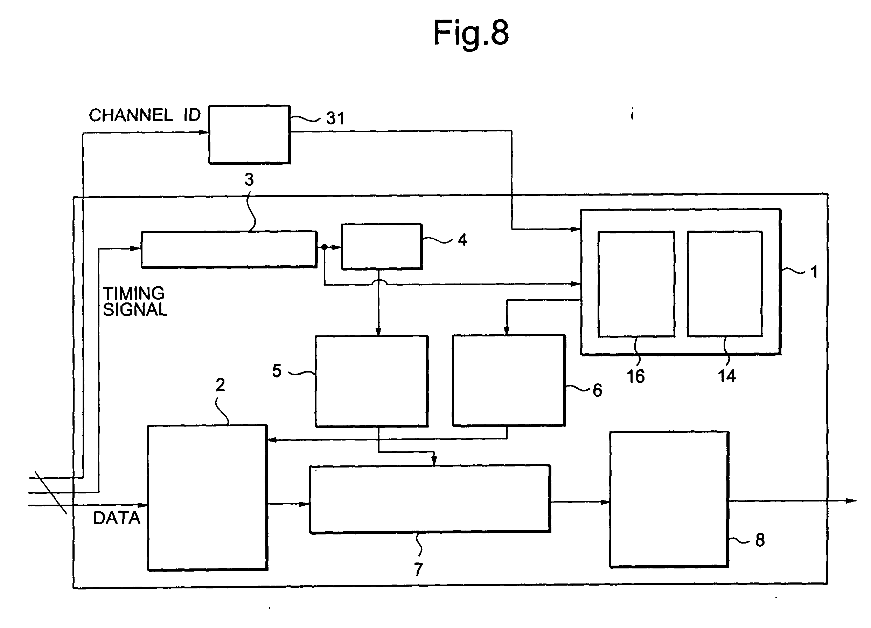

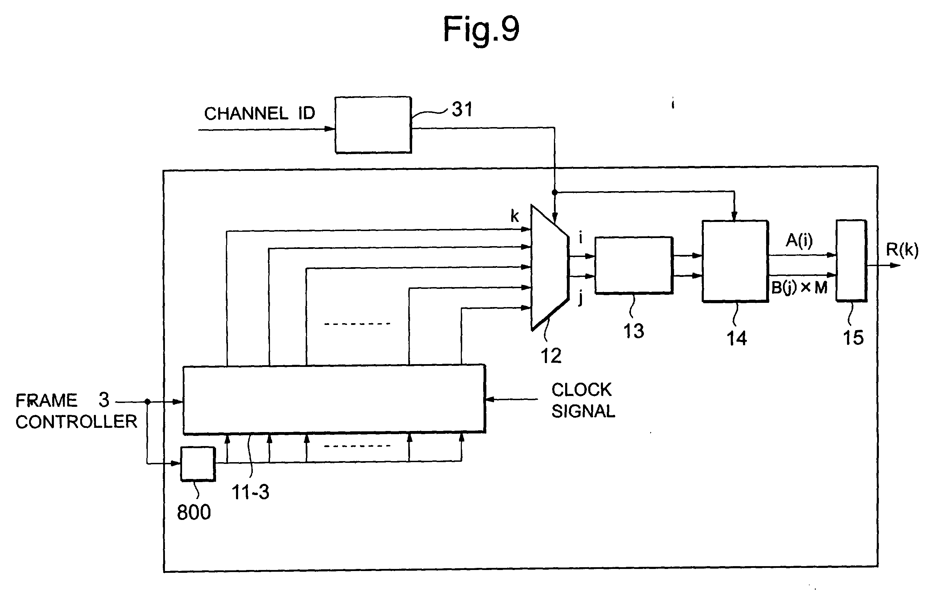

In the first and second embodiments as described above, each of the aforementioned address pattern memory units is used for a single channel. The present invention, however, is not limited to this. The address pattern memory units can be stored with a variety of address data for the respective different channels. Accordingly, an interleaver that can handle several different channels, according to the third embodiment of the present invention, will be described while referencing Figs. 8 and 9.

Fig. 8 illustrates the configuration of an interleaver of the third embodiment. The same functional elements as those in Figs. 3 and 6 are assigned the same reference numerals in this figure. As shown in Fig. 8, a microprocessor 31, which receives a channel ID and then outputs its corresponding operation mode selection signal to the address table generation unit 1, is connected to the interleaver. Upon reception of the operation mode selection signal from the microprocessor 31, the address table generation unit 1 operates in a mode corresponding to the operation mode selection signal.

Fig. 9 illustrates the detailed structure of the address table generation unit 1. The same functional elements as those in Figs. 4 and 7 are assigned the same reference numerals in this figure. As shown in Fig. 9, the address table generation unit 1 is comprised of a multiplexer 12a, a memory controller 13, an address pattern memory unit 14a, an adder 15, and an n-bit counter 11-3 where n corresponds to the expected maximum number of input data bits to be interleaved. In the case where the maximum number of input data bits is subjected to a (P x Q) interleaving process, n is equal to the sum of p and q that satisfy the following inequalities:

$$2^{p-1} < P \leqq 2^{p}$$

$$2^{q-1} < Q \leqq 2^{q}$$

For example, in the case of executing a (4 x 6) interleaving process, p = 2 and q = 3. Accordingly, a 5-bit counter is needed. In the case of executing a (216 x 128) interleaving process, p = 8 and q = 7. Accordingly, a 15-bit counter is needed.

In Fig. 9, the address pattern memory unit 14a is stored with multiple sets of row and column address data, each corresponding to a channel.

As described above, the microprocessor 31 gives the interleaver (more specifically the multiplexer 12a and address pattern memory unit 14a) an operation mode selection signal. It also stores the aforementioned multiple sets of row and column address data in the address pattern memory 14a before the interleaving operation starts. The address pattern memory unit 14a selects one of the multiple sets of row and column address data, and operates using the set in the same manner as that of the first embodiment. The multiplexer 12a is comprised of multiple circuits (not shown in the figure), each being able to generate the integers i and j from the address data k, and which are used for the specific channel designated by the microprocessor 31. It selects one of the above circuits in conformity with the operation mode selection signal, and multiplexes the address data k by the selected circuit.

Fourth embodiment

Next, an interleaver, according to the fourth embodiment of the present invention, will be described while referencing Fig. 10. The same functional elements as those in Figs. 3, 6, and 8 are assigned the same reference numerals in this figure. This interleaver of the fourth embodiment is structured by combining the structure of the third embodiment as shown in Fig. 8 with the structure of the second embodiment as shown in Fig. 7. Namely, according to the fourth embodiment, either the series of row address data A(i) or the series of column address data B(j) is generated by part of the circuit in Fig. 7 while maintaining the function of supporting multiple channels. The operating mode is directed by the microprocessor 31 in the same manner as done in the third embodiment.

(De-interleaver)

Incidentally, up to this point, only the interleavers of the respective first through fourth embodiments are described. De-interleavers corresponding to the respective interleavers can also be structured with similar configurations. A de-interleaver corresponding to the interleaver of the first embodiment as shown in Figs. 3 and 4 will be described below. What is different from the interleaver in Fig. 4 is the structure of the multiplexer 12 and the contents stored in the address pattern memory unit 14. The other elements are all the same as those in Figs. 3 and 4. Only the differing points will be described below.

    1. According to the interleaver of the first embodiment, the address pattern memory unit 14 is stored with A(i) = 0, 2, 4, 1, 3, 5 and B(j) = 0, 2, 1, 3. However, using a de-interleaver corresponding to the interleaver, the numeral elements of the respective A(i) and B(j) are exchanged from each other in such a manner as follows:

        ① A'(i) = 0, 2, 1, 3
        ② B'(j) = 0, 2, 4, 1, 3, 5

where in order to distinguish from the A(i) and B(j) of the interleaver, each of the matrices for the de-interleaver are attached with a prime mark ('). These A'(i) and B'(j) are stored in the address pattern memory unit 14 in place of A(i) and B(j).

    2. According to the interleaver, the integer i is equal to the quotient resulting from calculating the division of a bits-address k (shown in table 5) by N (i.e, 4); the integer j is equal to the remainder resulting from the above calculating. However, according to the de-interleaver, the above N is replaced with M (i.e., 6). Namely, the integer i is equal to the quotient resulting from calculating the division of a bits-address k (shown in table 5) by M (i.e, 6); the integer j is equal to the remainder resulting from the above calculating.

As described above, only these two changes allow the formation of a de-interleaver corresponding to the interleaver of the first embodiment.

In the similar manner, a de-interleaver corresponding to each of the interleavers of the respective second to fourth embodiments can also be easily structured.

Fifth embodiment

Next, a transmission apparatus 500, comprised of either one (52) of the interleavers of the respective first to fourth embodiments, and a receiver 501, comprised of either one (54) of the de-interleavers of the respective first to fourth embodiments, will be described while referencing Fig. 11.

The transmitter 500 is made up of an encoder 51, an interleaver 52, and an antenna 53a. The encoder 51 encodes 24-bit data that is to be transmitted, thus outputting a resulting encoded 24-bit data to the interleaver 52. The interleaver 52 subjects the encoded 24-bit data to its (4 x 6)-type interleaving process, and outputs the resulting signal in the air via the antenna 53a.

On the other hand, the receiver 501 is made up of a decoder 55, a de-interleaver 52, and an antenna 53b. The de-interleaver 54 receives a signal from the said transmitter 500 via the antenna 53b, and subjects the received signal to a (6 x 4)-type de-interleaving process so that the received signal can be relocated back to its original arrangement. The decoder 55 then decodes the rearranged signal.

The address pattern memory in the interleaver 52 is stored with, for example, a series of row data A(i) = 0, 1, 2, 3, 4, 5 and a series of column data B(j) = 0, 1, , 3. On the other hand, the address pattern memory in the de-interleaver 54 is stored with a series of row data A'(i') = 0, 1, 2, 3 and a series of column data B'(j') = 0, 1, 2, 3, 4, 5. Where, the integer i' is equal to the quotient resulting from dividing k by 6: the integer j' is equal to the remainder of the calculation.

In this case, the transmitter 500 transmits a series of data bits with their respective addresses being in the order of 0, 6, 12, 18, 1, 7, 13, 19, 2, 8, 14, 20, 3, 9, 15, 21, 4, 10, 16, 22, 5, 11, 17, 23. Accordingly, the receiver 501 receives and de-interleaves them into the series of data bits with their respective addresses being in the order of 0, 1, 2, 3, 4, 5, 6, 7, 8, 9, 10, 11, 12, 13, 14, 15, 16, 17, 18, 19. 20, 21, 22, 23.

Sixth embodiment

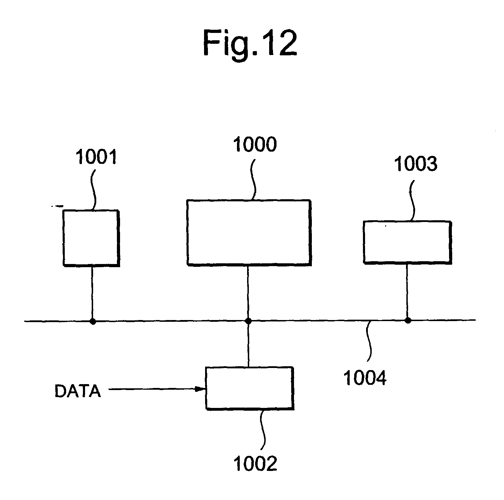

Next, a method of interleaving data bits, according to the sixth embodiment of the present invention, will be described. In the first embodiment, the interleaving process as shown in the flowchart of Fig. 5 is executed by the interleaver as shown in Figs. 3 and 4. According the sixth embodiment, the interleaving process in Fig. 5 is executed by the microprocessor system in Fig 12.

The microprocessor system is comprised of a microprocessor 1000, a RAM unit 1001, a ROM unit 1003, an input port, and a communication line 1004. The ROM unit 1001 is stored with program codes representing the procedure for the interleaving process in Fig. 5. The input port 1002 receives data bits, and transmits them to the RAM unit 1003, which accordingly stores them. The RAM unit 1003 is also stored with A(i) and B(j) as described in the first embodiment. The microprocessor 1000 reads the program codes out from the ROM unit 1001, and then interprets and executes them using a work area of the RAM unit 1003 so that the data bits stored in the RAM unit 1003 can be subjected to the interleaving process. Its resulting relocated data bits are also stored in an area of the RAM unit 1003.

In the description of the interleaving process in the first embodiment as shown in Fig. 5, the elements in Figs. 3 and 4 execute the process in each of the steps (S1 to S5). However, in this embodiment, the microprocessor 1000 executes the process in place of the elements in Figs. 3 and 4. The interleaving process of this embodiment will be described while referencing to Fig. 5.

In Fig. 5, during step S1, the microprocessor 1000 determines whether the number of input data bits (stored in the RAM unit 1003) is larger than a predetermined value. If yes, in step S2, one is added to the address data k. In step S3, the address data k is divided by N (i.e., 4) so that the quotient or integer i and remainder or integer j can be obtained. In step S4, an element in A(i) corresponding to the integer i and an element in B(j) corresponding to the integer j, which are stored in the RAM unit 1003, are taken out into internal resisters (not shown in the figure) in the microprocessor 1000. In step 5, the two elements stored in the internal resistors are summed up into a resulting address value R(k). The data bit in the address k is relocated into an address corresponding to R(k) in the RAM unit 1003. In order to relocate the next data bit, step S1 is again executed. The process steps S1 to S5 are repeated until all the data bits are completely relocated.

It is noted that the RAM unit 1003 can be stored with multiple pairs of A(i) and B(j) for the respective individual channels. One pair of them can be selected in accordance with a specific transmission channel at the beginning of the interleaving process as described above. Accordingly, steps S1 to S5 can be executed using the selected pair for the specific transmission channel.

An interleaver, a method of interleaving, a transmitter and a receiver, according to the present invention, have been described in connection with certain preferred embodiments. It is to be understood that the subject matter encompassed by the present invention is not limited to those specific embodiments. On the contrary, it is intended to include all alternatives, modifications, and equivalents as can be included within the spirit and scope of the following claims.

**Claims**

1. A method of interleaving pieces of data, comprising the following steps:

- a relocation-address calculation step of calculating a relocation address (R(k)) on the first row (A(i)) and the first column (B(j)) of address elements in a matrix, which has a desired relocation-address arrangement, and an address (k) of a piece of data; and

- a relocation step of relocating the said piece of data into the said relocation address (R(k)).

2. The method, according to claim 1, wherein the said relocation-address calculation step is comprised of the following sub-steps:

- a calculation sub-step of calculating the quotient (i) and remainder (j) resulting from dividing the said address (k) by an integer N, which is equal to the number of address elements in the first column (B(j));

- a selection sub-step of selecting an address element (A(i)) in the said first row (A (x) (x = 0, 1, 2, ...)) located at an address being equal to the said quotient (i) and an address element (B(j)) in the said first column (B(y) (y = 0, 1, 2, ...)) located at an address being equal to the said remainder (j); and

- a summation sub-step of summing up the selected address element (A(i)) and a value, resulting from multiplying the selected address element (B(j)) by an integer M that is equal to the number of address elements in the first row (A(i)), into the said relocation address (R(k)).

3. The method, according to claim 1, wherein an address element in the said first row (A(i)) results from selecting both an address element in the first column (C(m)) in a matrix made up of the said address elements of the said first row (A(i)), and an address element in the first row (D(n)) in the said matrix, and then summing up the respective, selected address elements.

4. The method, according to claim 1 or 2, further comprising a control step of allowing the said relocation-address calculation step and the said relocation step to repeat their operations for all the pieces of data.

5. The method, according to claim 1, 2 or 3, further comprising a mode selection step of selecting one of a plurality of individual first rows of address elements and one of a plurality of individual first columns of address elements.

6. A method of de-interleaving pieces of data, comprising the following steps:

- a relocation-address calculation step of calculating a relocation address (R(k)) on the first row (A'(i)) and the first column (B'(j)) of address elements in a matrix, which has a desired relocation-address arrangement, and an address (k) of a piece of data; and

- a relocation step of relocating the said piece of data into the said relocation address (R(k));

wherein the address elements in the said first row (A'(i)) are equal to the address elements in the first column (B(j)) in a matrix, which has a desired relocation-address arrangement that is used for an interleaving method; the address elements in the said first column (B'(j)) are equal to the address elements in the first row (A(i)) in the said matrix.

7. An interleaver, comprising the following components:

- a relocation-address calculator (1, 3), which calculates a relocation address (R(k)) on the first row (A(i)) and the first column (B(j)) of address elements in a matrix with a desired relocation-address arrangement, and an address (k) of a piece of data; and
- a relocation unit (6, 7, 5, 4), which relocates the said piece of data into the said relocation address (R(k)).

8. The interleaver, according to claim 7, wherein the said relocation-address calculator (4, 1) is comprised of a multiplexer (12), which outputs a first integer (i) and a second integer (j) that are equivalent to the respective quotient and remainder resulting from dividing the said address (k) by an integer N, which is equal to the number of address elements in the first column (B(j)).

9. The interleaver, according to claim 8, wherein the said relocation-address calculator (3, 1) is further comprised of an address pattern memory unit (14), which is stored with the said first row (A(i)) of address elements, and columnar address elements resulting from multiplying the first column (B(j)) of address elements by an integer M that is equal to the number of address elements in the first row (A(i)), and which selects and outputs both one of the address elements in the said first row (A(i)) and one of the address elements in the said first column (B(j)) in conformity with the said first integer (i) and the said second integer (j).

10. The interleaver, according to claim 9, wherein the said relocation-address calculator (3, 1) is further comprised of an adder (15), which sums up the selected address elements into a resulting relocation address (R(k)).

11. The interleaver, according to claim 10, wherein the said relocation-address calculator (3, 1) is further comprised of a counter (11-1, 11-2), which counts up the number of input pieces of data and outputs the counted value (k), which is equivalent to the said address (k), to the said multiplexer (12).

12. The interleaver, according to claim 8, 9, 10, or 11, wherein the said relocation-address calculator (3, 1) is further comprised of a first-row calculator (121, 130, 140, 15), which calculates an address element of the said first row (A(i)) on both an address element in the first column (C(m)) in a matrix, made up of the said address elements of the said first row (A(i)), and an address element in the first row (D(n)) in the said matrix, and the said first integer (i).

13. The interleaver, according to claim 9, 10, 11 or 12, wherein the said address pattern memory unit (14) is further stored with a plurality of individual first rows and first columns of address elements, and a mode selector (31) selects a pair of ones of the plurality of individual first rows and first columns.

14. A de-interleaver, comprising the following components:

- a relocation-address calculator (3, 1), which calculates a relocation address (R(k)) on the first row (A'(i)) and the first column (B'(j)) of address elements in a matrix with a desired relocation-address arrangement, and an address (k) of a piece of data; and
- a relocation unit (6, 7, 5, 4), which relocates the said piece of data into the said relocation address (R(k));
- wherein the address elements in the said first row (A'(i)) are equal to the address elements in the first column (B(j)) in a matrix, which has a desired relocation-address arrangement that is used for an interleaving method; the address elements in the said first column (B'(j)) are equal to the address elements in the first row (A(i)) in the said matrix.

15. A transmitter, comprising the following components:

an encoder, which encodes transmission data; and
an interleaver, comprised of the following units:

- a relocation-address calculator (1, 3), which calculates a relocation address (R(k)) on the first row (A(i)) and the first column (B(j)) of address elements in a matrix with a desired relocation-address arrangement, and an address (k) of a piece of the encoded transmission data;

and

- a relocation unit (6, 7, 5, 4), which relocates the said piece of the encoded transmission data into the said relocation address (R(k)).

16. A receiver, comprising the following components:

a de-interleaver, comprised of the following units:

- a relocation-address calculator (3, 1), which calculates a relocation address (R(k)) on the first row (A'(i)) and the first column (B'(j)) of address elements in a matrix with a desired relocation-address arrangement, and an address (k) of a piece of encoded data; and
- a relocation unit (6, 7, 5, 4), which relocates the said piece of encoded data into the said relocation address (R(k)); wherein the address elements in the said first row (A'(i)) are equal to the address elements in the first column (B(j)) in a matrix, which has a desired relocation-address arrangement that is used by a transmitter; the address elements in the said first column (B'(j)) are equal to the address elements in the first row (A(i)) in the said matrix; and

a decoder, which decodes each pieces of the relocated, encoded data.

# Fig.1 PRIOR ART

EP 1 020 996 A1

Fig.2 PRIOR ART

CHANNEL ID — 111

103

TIMING SIGNAL

104

105

106

101a

102

107

108

DATA

# Fig.3

EP 1 020 996 A1

Fig.4

EP 1 020 996 A1

# Fig.5

START

NUMBER
OF INPUT BITS>COUNTED
VALUE — S1

No

Yes

COUNT UP — S2

MULTIPLEXER OUTPUTS
i AND j — S3

ADDRESS PATTERN MEMORY
UNIT OUTPUTS
A(i) AND B(j) × M — S4

ADDER OUTPUTS R(k) — S5

END

# Fig.6

TIMING
SIGNAL

R(k)

DATA

EP 1 020 996 A1

Fig.7

Fig.8

CHANNEL ID

31

3

TIMING SIGNAL

4

5

6

2

DATA

7

8

1

14

16

# Fig.9

EP 1 020 996 A1

# Fig.10

EP 1 020 996 A1

CHANNEL ID

TIMING
SIGNAL

DATA

# Fig.11

EP 1 020 996 A1

500

501

53a   53b

51   52   54   55

# Fig.12

**European Patent Office**

## EUROPEAN SEARCH REPORT

Application Number

EP 00 10 0155

### DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| Y | US 5 063 533 A (ERHART RICHARD A ET AL) 5 November 1991 (1991-11-05)<br>* abstract *<br>* figure 5 *<br>--- | 1-16 | H03M13/27 |
| Y | TAKESHITA O Y ET AL: "NEW CLASSES OF ALGEBRAIC INTERLEAVERS FOR TURBO-CODES" IEEE INTERNATIONAL SYMPOSIUM ON INFORMATION THEORY,US,NEW YORK, NY: IEEE, 1998, page 419 XP000884278 ISBN: 0-7803-5001-4<br>* the whole document *<br>--- | 1-16 | |
| P,X | EP 0 952 673 A (NIPPON TELEGRAPH & TELEPHONE) 27 October 1999 (1999-10-27)<br>* abstract *<br>* page 10, line 35 - page 11, line 15 *<br>* figure 13 *<br>----- | 1-16 | |
| | | | **TECHNICAL FIELDS SEARCHED (Int.Cl.7)**<br><br>H03M |

The present search report has been drawn up for all claims

| Place of search | Date of completion of the search | Examiner |
|---|---|---|
| THE HAGUE | 27 April 2000 | Barel-Faucheux, C |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

& : member of the same patent family, corresponding
    document

EPO FORM 1503 03.82 (P04C01)

## ANNEX TO THE EUROPEAN SEARCH REPORT
## ON EUROPEAN PATENT APPLICATION NO.

EP 00 10 0155

This annex lists the patent family members relating to the patent documents cited in the above-mentioned European search report.
The members are as contained in the European Patent Office EDP file on
The European Patent Office is in no way liable for these particulars which are merely given for the purpose of information.

27-04-2000

| Patent document cited in search report | Publication date | Patent family member(s) | Publication date |
|---|---|---|---|
| US 5063533 A | 05-11-1991 | NONE | |
| EP 0952673 A | 27-10-1999 | WO 9925069 A | 20-05-1999 |

EPO FORM P0459

For more details about this annex : see Official Journal of the European Patent Office, No. 12/82